# EUROPEAN PATENT APPLICATION

(11) **EP 3 834 643 A1**
(43) Date of publication of application: **16.06.2021**
(21) Application number: 20212655.3
(22) Date of filing: 09.12.2020
(51) Int. Cl.: A41D 1/00, A41H 43/04, H01L 23/538

(54) **SEMI-FINISHED PRODUCT OF ELECTRONIC CIRCUIT AND METHOD FOR ITS PRODUCTION**

(30) Priority: 10.12.2019 IT 201900023505; 10.12.2019 IT 201900023508
(71) Applicant: D-Air Lab S.r.l., 36100 Vicenza (IT)
(72) Inventor: RONCO, Luigi, 36100 Vicenza (IT); MANUZZI, Marco, 36100 Vicenza (IT); PIOVESAN, Alberto, 36100 Vicenza (IT)
(74) Representative: Manfrin, Marta

(57) **Abstract**

The present disclosure refers to a production method for a semi-finished product or a part of a semi-finished product, and to a semi-finished product or a part of a semi-finished product. In particular, said semi-finished product or a part of a semi-finished product, is particularly suitable for being used in the production of garments or portions of garments.

The method according to the present disclosure comprises:
- providing a layer of glue (10);
- providing at least one electrically conductive component (20);
- associating or fixing the at least one electrically conductive component (20), obtaining a single body including the layer of glue (10) and the electrically conductive component (20).

The semi-finished product or a part of a semi-finished product according to the present disclosure comprises:
- a layer of glue (10),
- at least one electrically conductive component (20) associated or fixed to the glue layer (10) to form a single body with said glue layer (10),
and wherein said at least one conductive component (20) is intended for or adapted to form at least one conductive track of the electronic and/or electrical circuit.

## Description

The present disclosure refers to a production method for producing a semi-finished product, or a part of a semi-finished product intended to include a portion of an electronic and/or electrical circuit, and to a semi-finished product or a part of a semi-finished product thus produced. In particular, said semi-finished product or a part of a semi-finished product is particularly suitable for being used in the production of garments or portions of garments, accessories including a portion of an electronic and/or electrical circuit.

An electric circuit is a closed path formed by electrical elements, interconnected with each other, so as to allow an electric current to move through continuously. One or more electronic components can be connected along an electric circuit, also through which an electric current can move continuously, thus forming an electronic circuit.

Within the scope of this disclosure, the semi-finished product is produced in such a way as to include at least a portion of said electrical circuit, or one of its components. To this end, the semi-finished product can also include a single electronic component.

Electric and electronic circuits are widely used in various applications in many industrial sectors, such as the production of clothing. In fact, nowadays there are known clothing or clothing accessories, in particular technical clothing such as sports and/or personal protective clothing, including electrical and/or electronic circuits. Such known garments include electrical circuits connected, or capable of being connected, to electronic devices of various kinds, such as for example motion sensors, touch sensors, screens, emergency call activators, power supply devices, lighting devices (eg , LED lights).

To make such garments there is therefore the need to arrange, on them or on a portion of them, so-called conductive tracks or conductive tracks, that is to say the sections of the electrically conductive path of the electrical circuit, suitable for allowing generation of electric current when a difference in electric potential is applied to two ends of said electric circuit. Therefore, the electronic devices are electrically connected or connectable along said electrically conductive tracks or to said electrically conductive tracks.

In the context of the known art, this need is satisfied by applying cables in electrically conductive material and/or printed circuit boards to said clothing. The cables in electrically conductive material and/or printed circuit boards are applied directly to the structure or body of the garment or to a piece or layer of fabric, such as an inner lining, of the garment.

It is clear that the path of the electrically conductive cables and/or the positions of the printed circuit boards must be carefully studied in the design phase of the garment in order to minimize the perception of these elements by the user, especially while wearing of the garment.

Therefore, once the path or position has been chosen, the cables in electrically conductive material and/or printed circuit boards must be applied precisely to the garment or a portion of the garment.

In addition, cables made of electrically conductive material and/or printed circuit boards must be firmly applied to the garment, or to the portion of the garment, to prevent them from moving during the wearing of the latter and, consequently, they can break or hinder the user's movements.

Another requirement is that the electric cable is subjected to as little tension as possible in order to ensure ample range of movement to the garment or wearable article, without the risk of damaging the electric cable.

For this reason, traditionally, cables in electrically conductive material are applied to the garment, or to a portion of the garment, creating conduits on a layer of fabric, also in fabric, within which the cables in electrically conductive material are inserted. Similarly, fabric pockets are created for printed circuit boards into which said boards are inserted.

During these production phases, the fabric layer of the garment, or of the portion of garment, must be held in place to ensure that said channels or pockets are made in the desired position and subsequently the cables made of electrically conductive material or the printed circuit board are slipped inside the latter. As it can be easily understood, these operations require long production times and many processing steps.

The present disclosure starts from an innovative solution idea of providing a semi-finished product, or a part of a semi-finished product, and a respective method for the production of such a semi-finished product, or a part of such a semi-finished product, capable of exceeding or at least reducing the drawbacks mentioned in relation to the known art and/or achieve further advantages.

This is achieved through a semi-finished product or a part of a semi-finished product and a related production method, according to the respective independent claims. Furthermore, according to the respective independent claims, a garment or a portion of a garment, or alternatively other wearable article or wearable accessory, comprising a semi-finished product or part of a semi-finished product, and a use of a semi-finished product or part of a semi-finished product is made available to make a garment or a portion of a garment, or alternatively another article or accessory. Secondary characteristics and particular embodiments of the object of this disclosure are defined in the respective dependent claims.

In practice, according to the present disclosure, it is avoided to connect the electric threads or electronic components directly to the fabric by themselves, but a semi-finished product is created, i.e. an intermediate product that allows a better handling of the electrical and/or electronic components, and greater ease of assembly with the fabric or other component of the garment, or with another article where the semi-finished product is assembled.

In particular, the production method for producing a semi-finished product or a part of a semi-finished product according to the present disclosure comprises:
- providing a temporary layer or disposable layer;
- providing at least one printed circuit board;
- providing at least one electrically conductive thread or yarn
- providing at least one additional thread or yarn;
- associating the electrically conductive thread or yarn to, or depositing the electrically conductive thread or yarn on, the disposable layer and the printed circuit board;
- sewing or embroidering the additional thread or yarn on the disposable layer and on the printed circuit board in order to block or to restrain (to stop) the electrically conductive thread or yarn on the disposable layer and on the printed circuit board.

By printed circuit board it is meant a finished printed circuit board, i.e. a board that may be commercially available.

In practice, the method provides for initially depositing the same conductive thread from the printed circuit board to the temporary or disposable layer without constraints, and blocking the conductive thread by embroidering another thread or yarn that can be easily embroidered. The additional thread or yarn is advantageously a thread or yarn suitable for embroidery, so as not to require necessarily embroidery or sewing of the electrically conductive thread. The electrically conductive thread can therefore withstand the minimum voltage in the production phase. The additional thread or yarn can therefore also be a common thread or yarn, in polyester, cotton or other suitable material, not of the electrically conductive type.

Preferably, it is envisaged to embroider the additional thread or yarn loosely on the printed circuit board. Loosely embroidering, or binding, involves making a hole in the printed circuit board and inserting the additional thread or yarn into the hole in the printed circuit board, and forming a winding, or loop, and wherein said winding or loop is configured to define a free space between the additional thread or yarn and the electronic board. In other words, the winding or loop is very wide and it does not tight on the electronic board. In this way, the electronic board is not rigidly connected to the additional thread or yarn, nor to the electrically conductive thread.

A single / semi-finished body is obtained including the disposable layer or temporary layer, the additional thread or yarn, the electrically conductive thread or yarn and the printed circuit board, wherein a relative movement is allowed for the printed circuit board with respect to the electrically conductive thread or yarn, which adapts to the movements of the body of a user once the semi-finished product is received in a garment, while ensuring a locking or stabilization of the electrically conductive thread or yarn.

The set formed by the disposable layer, the printed circuit board and the electrically conductive yarn or thread, and the additional thread is in fact an autonomous semi-finished product that can then be used for the subsequent phases to create a garment or a part of a garment, or another item which may have a printed circuit. In other words, with the sewing or embroidery of the additional thread or yarn, the disposable layer and the electrically conductive thread or yarn and the printed circuit board become a structurally single piece, which can then be manipulated or used according to specific needs, without complicated processing for the electrically conductive thread or yarn and without creating stress on the electrically conductive thread or yarn. In fact, at the same time, the electrically conductive thread or yarn is not only not directly involved in the embroidery or sewing, but also has a certain degree of freedom with respect to the electronic board.

In practice, preferably only the additional thread or yarn is inserted through the temporary layer or disposable layer and is inserted through the printed circuit board. In other words, preferably only the additional thread or yarn is inserted in a zig zag manner in respective through holes in the temporary layer or disposable layer, and is inserted in a through hole in the printed circuit board.

In other words, following the implementation of the production method according to the present disclosure, the disposable layer, the additional thread or yarn, and the electrically conductive thread or yarn and the printed circuit board are not separable or detachable from each other, with the exception of a, irreversibly, that is irreparably, tampering of the obtained single body. In other words, during the processing step, the disposable layer and the electrically conductive thread or yarn and the printed circuit board form an individually manoeuvrable or manageable body.

This semi-finished product can be easily incorporated between layers of a garment or, alternatively, of an article to be obtained intended to have an electrical circuit. In practice, in turn, the semi-finished product is intended to be applied to the garment or to a portion thereof, or to constitute part of the structure, that is to say of the body, of the garment or of a portion thereof, or alternatively to be part of the article to be obtained.

Advantageously, this entails the possibility of obtaining a single body on which the printed circuit board and conductive tracks are already made, or subsequently manufacturable, and of manipulating said single body, for example, to join it directly to one or more layers of the garment, or of a portion thereof. In this way it is avoided having to make raceways or pockets or other structures and having to insert electric or electronic elements inside them to form said conductive tracks.

The term "disposable layer" or "temporary layer" means a layer that acts as a temporary support for the electrically conductive thread or yarn, and which can be lost in the subsequent stages of preparation of the final product to be obtained, or which is used as at least temporary support, without requiring a technical or structural function after the embroidery or sewing of the thread to the printed circuit board.

It follows that the electrically conductive thread or yarn can avoid being directly subjected to a seam or embroidery, and cannot be rigidly connected either to the electronic board or to the subsequent layers once the semi-finished product is incorporated between other layers, although it is connected to they.

In practice, according to the invention, the electrically conductive thread or yarn is first associated with a disposable layer, or at least that has only a temporary support function, and with the printed circuit board, in order to create an electrical contact; then subsequently the additional thread or yarn is sewn or embroidered on the disposable layer or on the printed circuit board, to stop or block the electrically conductive thread or yarn. In the garment or article that incorporates the semi-finished product, the disposable layer can then be melted, deformed or removed by appropriate treatment, in order to leave the conductive thread with the lowest possible tension.

It follows that, at the end of the production method, the disposable layer could be lost or eliminated, and in fact no longer be connected to the electrically conductive thread or yarn.

Furthermore, as mentioned above, the semi-finished product is intended to be a part or component of the semi-finished product which will then form the garment or the final article. Since it is a disposable layer, it is consequently not necessarily part of the fabric that forms the final garment. But it is a temporary support layer. It follows that, in the finished product, the electrically conductive thread or electrically conductive yarn may in fact not be completely sewn or embroidered to the disposable layer, and to any layer of fabric or knit of the garment, or another article, or to the printed circuit board.

At the same time, the electrically conductive thread or yarn, once blocked by the additional thread or yarn, can already constitute a conductive track of the electric and/or electronic circuit or alternatively, once assembled with other components, or completed with, or subjected to further production steps, is intended to create a conductive track for the electric / electronic circuit.

In other words, in one embodiment, the electrically conductive thread once clamped on the disposable layer defines conductive tracks which are then extended to the printed circuit board, and more preferably to electrically conductive pads of the printed circuit board. In practice, at the time of sewing or embroidering the additional thread or yarn, the electrically conductive thread is placed on the disposable layer, and on the printed circuit board, and even more preferably on one or more of the conductive pads of the printed circuit board, so that no further connections are required.

It follows that the single body obtained at the end of the implementation of the aforementioned method includes the disposable layer together with the additional thread or yarn, the electrically conductive thread, and the printed circuit board electrically connected to each other. In other words, an electrical connection is made between the electrically conductive tracks made by the electrically conductive threads on the disposable layer and the pads of the printed circuit board. The electrically conductive tracks are therefore also formed on the printed circuit board at least in the regions of the electrically conductive pads.

According to a further preferred aspect of the method of the present disclosure, the printed circuit board is a flexible printed circuit board, preferably having at least one electrically conductive pad. Flexible printed circuit boards allow you to replace rigid printed boards mated to electrical connectors. These flexible printed circuit boards are able to flex, up to a maximum radius of curvature, during their use without suffering damage; therefore, advantageously, these flexible printed circuit boards do not represent elements which add substantial or perceptible rigidity to the structures or elements to which they are applied, or associated.

According to a preferred aspect of the method of the present disclosure, the disposable layer can advantageously be a heat-alterable or heat-modifiable sheet or film. In this way, after sewing or embroidery of the thread, the semi-finished product or portion of the semi-finished product can be sandwiched between at least two layers, or more layers. The multi-layered structure obtained can be hot worked, to deform the disposable layers and make it, for example, more homogeneous or compliant with the other layers.

Even more preferably, the disposable layer is a layer of glue, or an adhesive layer, or bonding layer intended to act as a connecting element of layers for subsequent processing.

Preferably, the disposable layer is a sheet of glue. That is, preferably, the glue layer is a singularly independent element or structure on which the additional thread or yarn can be embroidered by blocking or harnessing the electrically conductive yarn or thread. As a result, no additional supports or connection systems are required on which to apply the electrically conductive thread or yarn. Preferably, the glue layer is a substantially two-dimensional and flexible element; this means that if it is applied directly to the garment, or to any additional flexible elements of the semi-finished product that are subsequently applied to the garment, it is able to flex following the flexing of the garment. That is to say that the layer of glue is lost between the layers of the garment and "moves" together with the garment and is therefore not perceived by the user as an obstacle or as an obstacle to movement.

The glue layer thus has a double function of momentarily supporting the electrically conductive thread or yarn by means of the additional thread or yarn and fixing the layers together.

The glue sheet may have a ribbon shape to cover only the electrically conductive thread or yarn.

When it comes to glue or similar adhesive film, a comfortable waterproofing of electrically conductive components can also be achieved. The glue layer melts after the hot working phase and embraces or incorporates the additional thread or yarn, the electrically conductive thread or yarn and the printed circuit board. This allows the electrically conductive thread or yarn and/or printed circuit boards to be insulated, so as to make them resistant to washing, atmospheric agents and/or moisture and body heat generated by the wearer of the garment on which they are applied, but without subjecting them to tension. It is thus possible to avoid previously covering the electrically conductive material and/or the printed circuit boards with a layer of insulating and waterproof material. In other words, this allows you to avoid a further operation, which lengthens and complicates the production process of the garment.

The insulation also makes it possible to close "ports" connecting the electronic components to the cables and/or printed boards that may otherwise represent openings and therefore weak points that allow water and humidity to come into contact with the cables and/or printed circuit boards and any other electronic components favouring the onset of oxidative phenomena. Thanks to the glue sheet, consequently, it is possible to improve resistance to washing, atmospheric agents and/or humidity and body heat generated by the wearer. It is therefore possible to isolate as much as possible the area around these connectors, or ports.

Even the printed circuit board can be previously fixed to the disposable layer, before sewing or embroidering the additional thread or yarn, to block the electrically conductive thread or yarn.

It should be noted that, advantageously, a thread made of electrically conductive material creates a smaller footprint and has less rigidity than a cable made of electrically conductive material. Furthermore, the fact that the electrically conductive thread is blocked by means of the additional embroidered or sewn thread or yarn on the disposable layer, allows the electrically conductive tracks to be easily made or traced following rather complex patterns. In fact, a thread made of conductive material having a lower rigidity than a cable can be associated or fixed to another element also making bends or angles of rather limited amplitudes. In addition, the additional thread or yarn can be embroidered or sewn using traditional sewing machines, widely available in the context of the known technique and commonly used in the production processes for making garments.

In addition, according to another preferred aspect of the method of the present disclosure, the embroidery or sewing of the additional thread or yarn on the electrically conductive thread, on the disposable layer and on the printed circuit board takes place in a single production step. In particular, said single production phase consists in embroidering or sewing the additional thread or yarn continuously on the electrically conductive thread, on the disposable layer and on the flexible printed circuit board, preferably at least in the region of an electrically conductive pad. Consequently, in a single step, it is possible to associate the flexible printed circuit board and the electrically conductive thread to the disposable layer.

That is to say that in a single processing step two effects are achieved, respectively the electrical connection between the electrically conductive thread and at least one of the conductive pads of the printed circuit board, and the union to the disposable layer, through the additional thread or yarn.

According to another preferred aspect of the method of the present disclosure, it is possible to prepare or provide a plurality of single bodies and to superimpose and associate said plurality of single bodies with each other, to form a single multilayer body. In particular, said single bodies are fixed or associated with each other so that the disposable layer of each single body at least partially covers the conductive component of the one or more single bodies to which it is associated.

According to this preferred aspect of the method, a single body is obtained, which can be individually manipulated or handled, comprising a plurality of single bodies superimposed or lying on each other but electrically isolated from each other at least in part. In this way, in the same portion of the semi-finished product in which the single multilayer body is incorporated or associated, there are different portions of electric and/or electronic circuit independent from each other.

Multiple layers of glue can also be provided.

According to another preferred aspect, the method of the present disclosure comprises providing a first laminate, including a first layer of fabric and a second layer of glue, and of providing a second laminate, including a second layer of fabric and a third layer of glue. Therefore, according to this method, the step of including the single body, or the single multilayer body, between the first laminate and the second laminate to form said semi-finished product is also provided. The disposable layer then comes into contact with the glue layers of the respective laminates. Also in this case, upon completion of the method, a multilayer semi-finished product formed by a single body or a single multilayer body between two layers of laminate is obtained. In other words, the semi-finished product thus obtained also appears as a single body or a single multilayer body placed between, or placed between, or between, or contained between, two layers of glue, each of which is respectively coupled to a layer of fabric. Therefore, in addition to being able to recognize the same advantages described in the previous paragraph, the use of layers of laminate, then of layers of glue pre-coupled with layers of fabric, allows to shorten the production process.

Furthermore, if a thermoplastic disposable layer is used, according to another preferred aspect of the method according to the present disclosure, the semi-finished product is advantageously subjected to thermo-pressing or thermo-forming. In other words, the semi-finished product is heated until the disposable layer softens. The disposable layer or layers of the single body or of the single multilayer body are brought to a temperature such that they melt completely or partially and are then subjected to a pressure. The melted or partially melted disposable layers are then press-bonded without filler material or other different connecting means. In this way, the electrically conductive component of each single body, and consequently the conductive tracks, between the disposable layers is embedded or drowned, especially if it is glue. Furthermore, the glue can partially penetrate into the meshes of the fabric layers thus drowning at least the first fabric layer and the second fabric layer as well. It follows that, soaked of glue, the meshes of the first fabric layer and of the second fabric layer are at least partially waterproof. Moreover, advantageously, in this way an even more cohesive structure is created, and it is more difficult to separate the different elements of the semi-finished product from each other.

The present disclosure also relates to a semi-finished product or part of a semi-finished product as described above. In particular, according to an aspect of the present disclosure, said semi-finished product or part of a semi-finished product comprises: a disposable layer, a printed circuit board, at least one electrically conductive thread or yarn and at least one additional thread or yarn embroidered or sewn on the layer and on the printed circuit board to block or stop the electrically conductive thread or yarn on the disposable layer and on the printed circuit board and form a single body with them. Furthermore, the electrically conductive thread or yarn once blocked by the additional thread or yarn is intended to, or suitable for, forming at least one conductive track of the electronic and/or electrical circuit. As anticipated, the electrically conductive thread or yarn is a component which alternatively already constitutes a conductive track of the electronic circuit or which, once assembled with other components or completed with other procedural steps, is intended to form a conductive track of the electronic circuit. The single body is intended, however, to be part of the semi-finished product or a component of the latter.

According to a preferred aspect of the semi-finished product according to the present disclosure, the disposable layer is a structurally independent sheet and has a first surface and a second surface opposite to each other. That is, the disposable layer is basically a two-dimensional structure or element, having two faces or surfaces opposite to each other. Preferably, said disposable layer is flexible, so as to minimize the contribution of rigid elements or components to the garment. Furthermore, preferably, the disposable layer is a thermoplastic sheet, preferably a polyurethane-based adhesive thermoplastic film, which deforms and melts with heat. Due to the embroidery or sewing, the additional thread or yarn crosses the disposable layer between the first surface and the second surface, with a substantially zig-zag, or wave, or sinusoidal pattern. In other words, the additional yarn or yarn passes from side to side the disposable layer and the printed circuit board. The additional thread or yarn is tied, interlaced, worked together with the disposable layer and with the printed circuit board, and intercepts or traps the electrically conductive thread or yarn.

More preferably, the electrically conductive thread is blocked in electrical contact with one or more of the conductive pads of the flexible printed circuit board. It follows that the single body is a layer of glue to which the electrically conductive thread and the flexible printed circuit board, in electrical connection between them, are fixed by means of said additional thread or yarn. Thus, an electrical connection is made between the electrically conductive tracks of electrically conductive thread and at least one of the electrically conductive pads of the flexible printed circuit board. In other words, the electrically conductive tracks made with the electrically conductive thread are extended up to the pads of the flexible printed circuit board. Stated otherwise, the electrically conductive tracks are also formed on the flexible printed circuit board up to at least one of the electrically conductive pads.

Even more precisely, the electrically conductive thread is blocked by the additional thread on one or more of the conductive pads of the flexible printed circuit board. That is to say that the electrical connection is made by means of contacting the said electrically conductive thread at one or more of the electrically conductive pads. In other words, the electrical connection between the electrically conductive thread and one or more electrically conductive pads is a physical connection, i.e. given by the direct physical contact between the electrically conductive thread and the electrically conductive pad. In particular, the additional thread or yarn by means of sewing stitches or embroidery stitches advantageously allows not to resort to welding the electrically conductive thread on one or more electrically conductive pads. Welding is a particularly laborious processing step that requires a lot of time and precision for the electrical connection obtained to be effective. In addition, the weld point between two elements, such as a portion of electrically conductive thread and an electrically conductive pad, represents a point of weakness. On the one hand, in fact, the welding point is subject to greater oxidative phenomena, with a consequent deterioration of the electrical conductivity of the structure at that point. On the other hand, moreover, the welding point represents a point of structural discontinuity and is therefore more subject to breakage.

Preferably, as said, the disposable layer is a thermoplastic layer, which is lost or diffused between other layers once the semi-finished product is sandwiched between other layers.

It follows that once coupled between other layers, only the additional thread or yarn is embroidered or sewn only on the printed circuit board, and results in the aforementioned zig-zag or sinusoidal configuration between the layers, unevenly incorporated in the layer a to lose.

According to another preferred aspect, the semi-finished product or part of a semi-finished product according to the present disclosure, comprising a first layer of fabric and a second layer of fabric and the single body or several single bodies is included between the first fabric layer and the second layer of fabric to form said semi-finished product. In other words, said semi-finished product comprises the single body enclosed between, or interposed between, or contained between the first fabric layer and the second fabric layer. It follows that the semi-finished product is, in turn, a "sandwich" structure or a multilayer structure.

The semi-finished product or part of a semi-finished product according to another preferred aspect of the present disclosure, can have further layers of glue or laminates including layers of fabric previously associated with layers of glue.

Finally, the present disclosure relates to a garment or a portion of a garment, or alternatively another article, comprising the semi-finished product or part of a semi-finished product according to one of the aspects defined above. In fact, as anticipated, the semi-finished product can be cut according to a design that is, cut following a precise shape, for example following the profiles or contours traced on a pattern. The portion of semi-finished product thus obtained can be used to make a portion of garment or to be associated with a portion of garment, or alternatively with another article. The portion of semi-finished product can be used or employed to make the structure or part of the structure or body of the garment, or alternatively of another article.

The present disclosure, therefore, also relates to the use of a semi-finished or part of a semi-finished product according to one of the aspects defined above to make a garment or a portion of a garment, or another article that is intended to have an electronic or electrical circuit or a part thereof. In particular, according to a preferred aspect of said use, the use or use of said semi-finished product or portion of semi-finished product is made to form the structure of the garment or portion of garment or to form a layer of the garment or portion of garment, or alternatively another article to be obtained.

It follows that the garment, or portion of garment, or alternatively other article or accessory are intended to include an electrical or electronic circuit.

Further advantages, characteristics and methods of use of the object of the present disclosure will become evident from the following detailed description of its embodiments, presented by way of non-limiting example.

It is however evident that each embodiment of the object of the present disclosure can present one or more of the advantages listed above; in any case it is not required that each embodiment have all the listed advantages simultaneously.

Reference will be made to the figures of the attached drawings, in which:
- Figure 1 represents an exploded view of a semi-finished product or a part of a semi-finished product according to a preferred aspect of the present disclosure;
- Figure 2 represents an exploded view of a semi-finished product or a part of a semi-finished product according to a preferred aspect of the present disclosure;
- Figure 3 shows an exploded view of a semi-finished product or a part of a semi-finished product according to a preferred aspect of the present disclosure;
- Figure 4 shows an exploded view of a semi-finished product or a part of a semi-finished product according to a preferred aspect of the present disclosure;
- Figure 5 shows an exploded view of a semi-finished product or a part of a semi-finished product according to a preferred aspect of the present disclosure;
- Figure 6 shows a perspective view of a semi-finished product or a part of a semi-finished product according to the preferred aspect of the present disclosure illustrated in Figure 5;
- Figure 7 shows a top view of an electrically conductive component of a semi-finished product or a part of a semi-finished product according to a preferred aspect of the present disclosure;
- Figure 8 shows a perspective view of the electrically conductive component of a semi-finished product, or a part of a semi-finished product according to the preferred aspect of the present disclosure illustrated in Figure 7;
- Figure 9 shows a top view of an electrically conductive component of a semi-finished product or a part of a semi-finished product according to a preferred aspect of the present disclosure;
   Figure 10 shows a view of a garment comprising a semi-finished product or a part of a semi-finished product according to the present disclosure;
- Figure 11 shows a detail view of Figure 9.

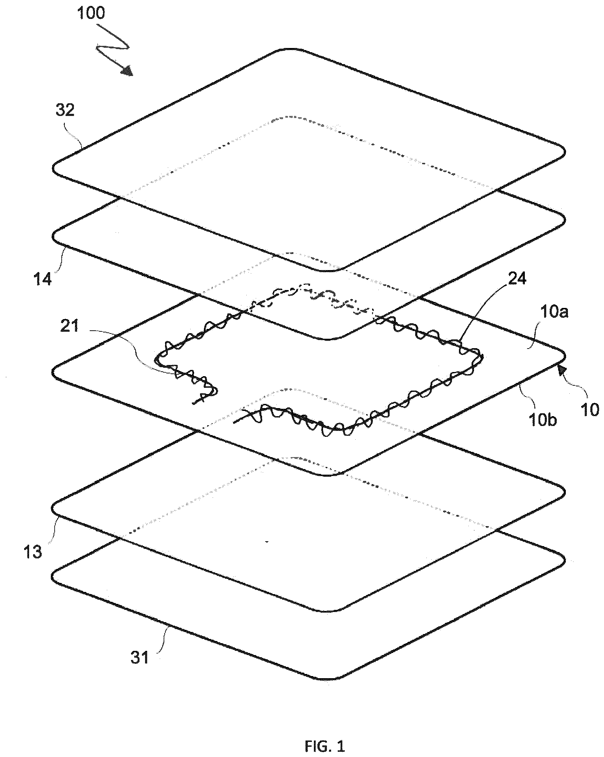

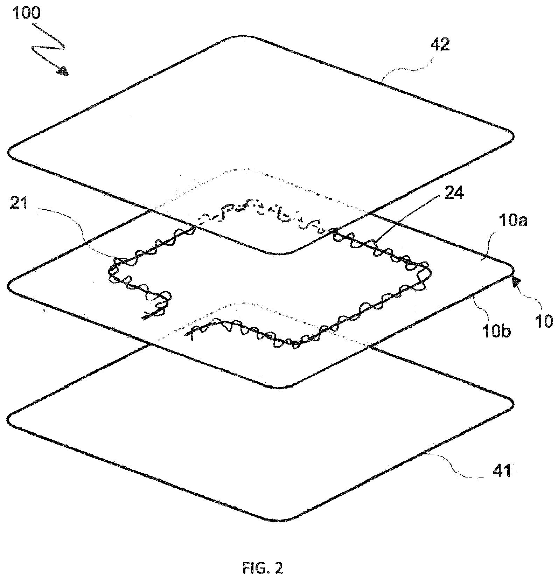

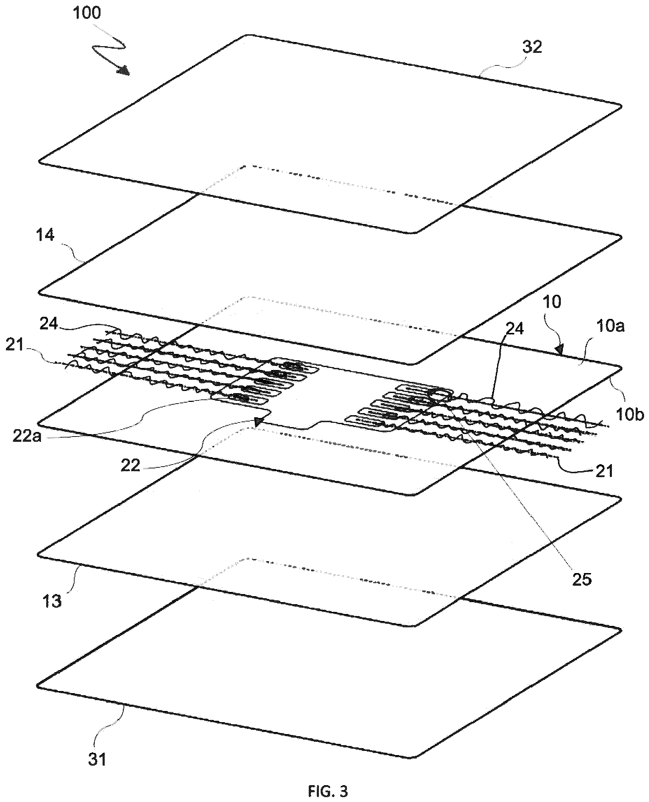

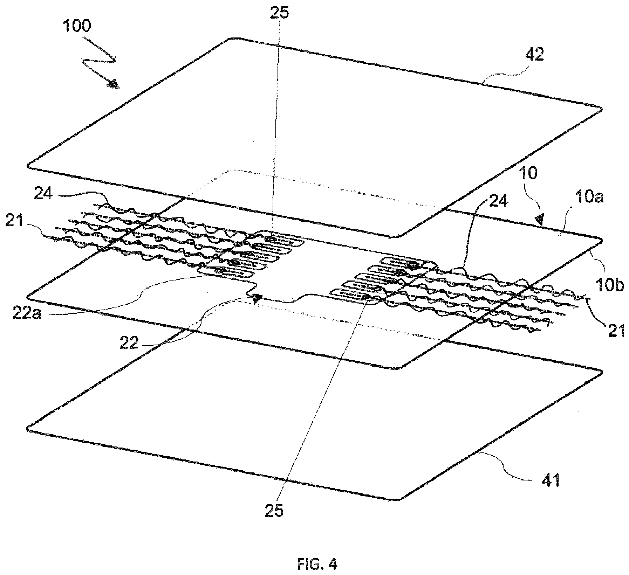

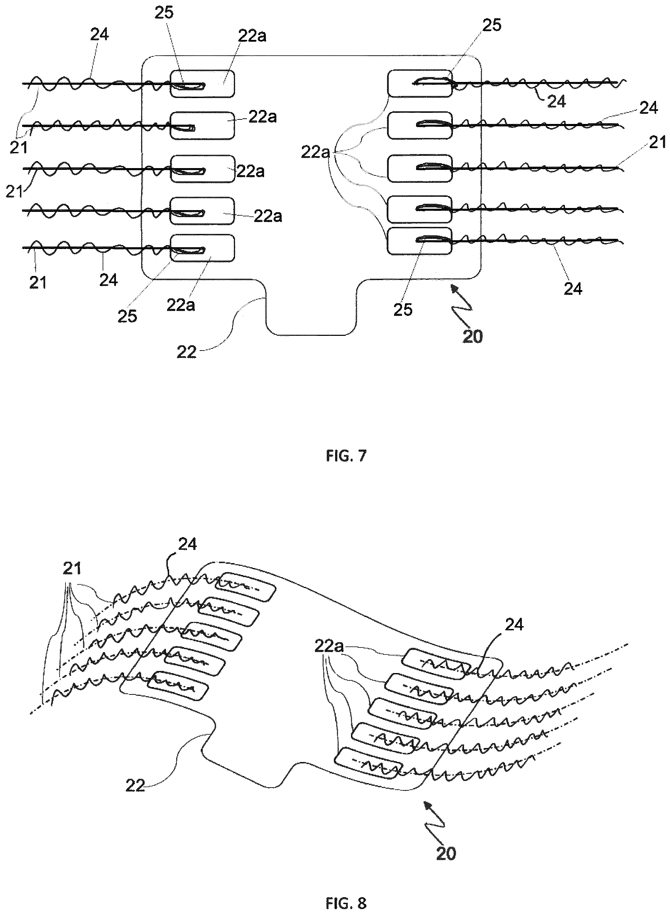

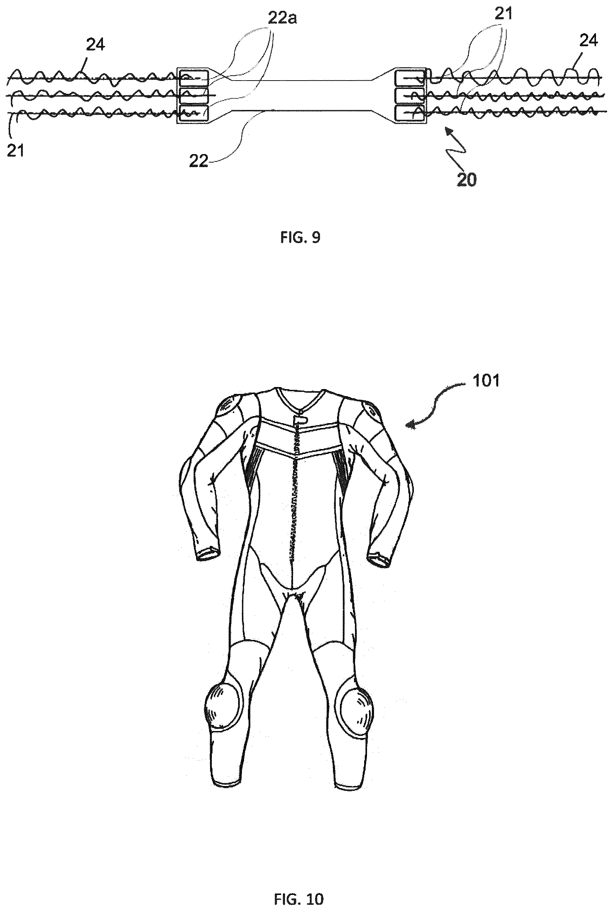

With reference to the attached figures 1-9 and 11, an embodiment of a semi-finished product or portion of a semi-finished product is indicated as a whole with the reference number 100. With reference to the attached figure 10, a garment 101 is illustrated comprising the semi-finished product or a part of a semi-finished product 100 according to the present disclosure.

The expression "semi-finished product" in the context of this disclosure means an intermediate product, ie a product which, while having a finished or semi-finished structure, is intended to be intimately inserted or associated with or integrated with further elements or components in order to make a composite finished product. Specifically, the semi-finished product, or the portion of the semi-finished product, according to the present disclosure is particularly adapted to be used in the subsequent production or manufacturing of a garment, or alternatively of another article or accessory; in particular, it is a garment or, alternatively, another article or accessory, which comprises an electric or electronic circuit.

In fact, the present disclosure also relates to a garment or a portion of a garment, or an article or accessory, which comprises a semi-finished product 100 or part of the semi-finished product 100, as described below. Similarly, the present disclosure also relates to the use of a semi-finished product 100 or part of a semi-finished product 100, in turn, as described below to make a garment or a portion of a garment. In particular, said semi-finished product 100, or a part thereof, can be used to create or to form the structure of the garment or the portion of the garment, or it represents, or is associated with, or incorporated into, a layer of the garment or of a portion of the garment. Alternatively, the application of the semi-finished product 100 can be envisaged for the creation of another article or wearable accessory.

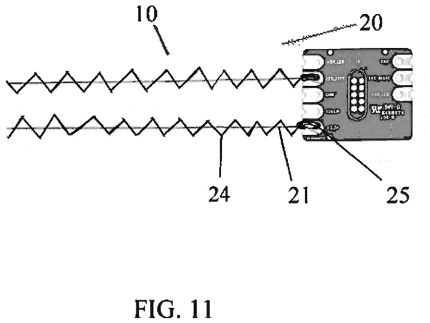

According to an aspect of the present disclosure, the semi-finished product 100 or part of the semi-finished product 100, which includes an electronic and/or electrical circuit portion, comprises a layer of glue, which acts as a disposable layer, or layer of adhesive, 10 and at least two electrically conductive components 20. In particular, the glue layer 10 and the electrically conductive components 20 are associated or fixed together by sewing or embroidery of an additional thread or yarn 24 (Figure 11) so as to form a single body, which represents or constitutes a component or part of the semi-finished product 100.

A single body means a monolithic body. In other words, the layer of glue 10 and each electrically conductive component 20 are joined to each other in a single piece. Structurally, therefore, the single body is a body or an element that can be individually manipulated or handled, wherein the layer of glue 10 and the electrically conductive components 20 are not separable, or disconnectable, from each other.

In particular, the glue layer 10 acts as a support or base for the irreversible application or fixing of the electrically conductive components 20. Preferably, the glue layer 10 is a structurally independent sheet or film. The glue layer 10 is a substantially two-dimensional solid element, which has a first surface 10a and a second surface 10b opposite to each other. Preferably the thickness of the glue layer 10 is chosen so that it is flexible. In particular, the thickness of said layer of glue 10 is preferably between 80µm and 120µm, even more preferably about 100µm. Preferably the glue layer 10 is a polyurethane-based adhesive film, even more preferably a polyurethane-based adhesive thermoplastic film.

Even more preferably, the electrically conductive components 20 are at least one electrically conductive thread 21 and a preferably flexible printed circuit board 22.

The electrically conductive thread 21 is intended to, or adapted to, form at least one conductive track of the electronic and/or electrical circuit of the semi-finished product 100 to be obtained. In other words, the electrically conductive thread 21 is configured to define, from the moment of its application or fixing to the glue layer, or possibly in a subsequent phase of the production of the semi-finished product 100, one or more conductive tracks or conductive tracks. The conductive tracks or traces constitute the sections of the electrically conductive path of the electric circuit along which an electric current can flow which is generated when a difference in electric potential is applied to two ends of said electric circuit. One or more electronic devices, such as for example sensors, batteries, displays, LED lights can or are electrically connected along said electrically conductive tracks or to said electrically conductive tracks.

The electrically conductive thread is associated with the glue layer 10 and with the flexible printed circuit board 22. The latter has one or more electrically conductive pads 22a, or a combination of these. The electrically conductive thread is electrically connected to one or more conductive pads 22a of the flexible printed circuit board 22.

According to a preferred aspect of the present disclosure, these flexible printed circuit boards 22 are configured to be able to flex, up to a maximum radius of curvature, during their use without being damaged and to then return to their original shape. A flexible printed circuit board comprises a base in plastic material and one or more electrically conductive pads 22a, for example in copper or gold or gold-coated copper, placed or coupled or made on said base. Generally, a flexible printed circuit board 22 comprises several electrically conductive pads 22a, connected to each other by means of electrically conductive tracks, obtained or engraved on the base. The electrically conductive pads 22a substantially act as electrical connectors with any other electrical elements or electronic devices or electronically conductive components.

By electrically conductive thread it is meant, in the context of this disclosure, a filiform element, formed by a single filament or by a plurality of intertwined filaments. Preferably, said electrically conductive thread 21 is made of metallic material; even more preferably in steel, silver, copper, gold.

In order to associate the electrically conductive thread 21 to the electronic printed circuit board and to the layer of glue, a further thread or yarn 24 is used as said.

The latter is suitable for use in combination with traditional sewing or embroidery machines. More specifically, the additional thread or yarn 24 is embroidered or sewn on said layer of glue 10, and the additional thread or yarn 24 is passed through the first surface 10a and the second surface 10b of the glue layer 10.

Preferably the additional thread or yarn 24 is embroidered or sewn on the glue layer 10 so as to cross the latter with a substantially zig-zag, or wave, or sinusoidal pattern. In other words, the additional thread or yarn 24 passes through the layer of glue 10, between the first surface 10a and the second surface 10b, making said zig-zag, wave, or sinusoidal pattern between the two surfaces 10a and 10b, of the layer of glue 10. In particular, this pattern is achieved by sewing or embroidering the additional thread or yarn 24 on said layer of glue 10.

The additional thread is sewn or embroidered by locking in place the electrically conductive thread 21 previously deposited on the glue layer 10 and on the printed circuit board 22. That is to say that the conductive tracks, in this case, are made by rows or lines of electrically conductive thread blocked by sewing or embroidery stitches connected or linked in continuity with each other.

The electrically conductive thread 21 is then secured by sewing or embroidering the additional thread or yarn 24 onto the glue layer and onto the one or more of the conductive pads 22a of the flexible printed circuit board 22. That is to say that said flexible circuit board 22 is electrically connected to said second electrically conductive thread 21 and blocked thereto by means of one or more sewing or embroidery stitches made on said electrically conductive thread 21 on one or more of the electrically conductive pads 22a. The electrical connection that is made between at least one of the electrically conductive pads 22a and the electrically conductive thread 21 is an intimate physical contact between the electrically conductive material of the thread 21 and the electrically conductive material of the electrically conductive pad 22a. Basically, the electrically conductive thread 22 is in contact with the entire internal surface of the through hole which is formed on the electrically conductive pad 22a before or at the time of the application of the sewing stitch for the additional thread or yarn 24.

The embroidery on the printed circuit board is made in such a way that the additional thread or yarn 21 is loose with respect to the printed circuit board. Basically, the thread forms a loose knot or tie on the printed circuit board.

The connection is a wide loop 25, shaped like a winding which does not tighten the electronic printed circuit board. It follows that the electrically conductive thread may not be tensioned in case of bending of the semi-finished product, or of the garment made with the semi-finished product.

It follows that the electrically conductive thread 21 is not sewn directly but blocked by the additional thread or yarn 24. According to this aspect of the present disclosure, the additional thread or yarn 24 can also be sewn or embroidered on the basis of the printed circuit board 22 until it reaches at least one of the electrically conductive pads 22a where the electrically conductive thread 21 is located, so as to block it. In other words, the conductive tracks formed by the electrically conductive thread 21 also continue on the printed circuit board 22 up to at least one of the electrically conductive pads 22a. The sewing or embroidery stitches made by means of the additional thread or yarn 24 on the flexible printed circuit board 22 can also reach the layer of glue to which said flexible printed circuit board 22 is associated. (figure 11)

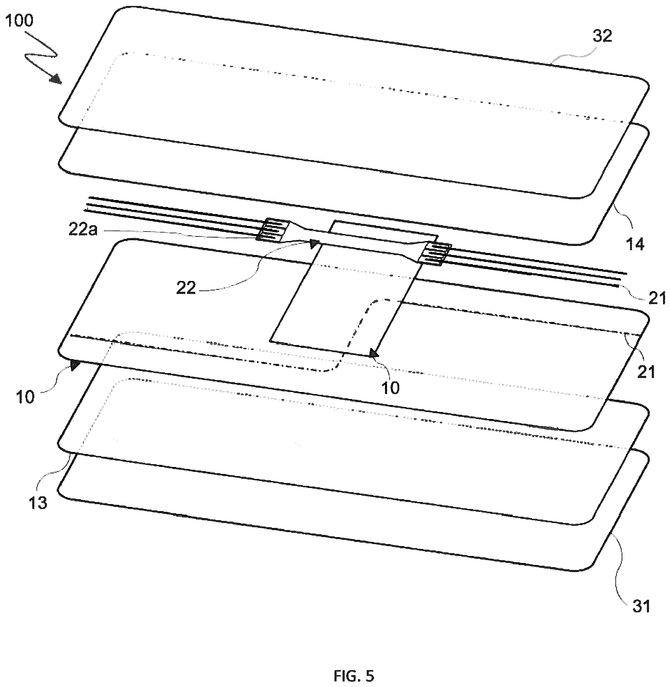

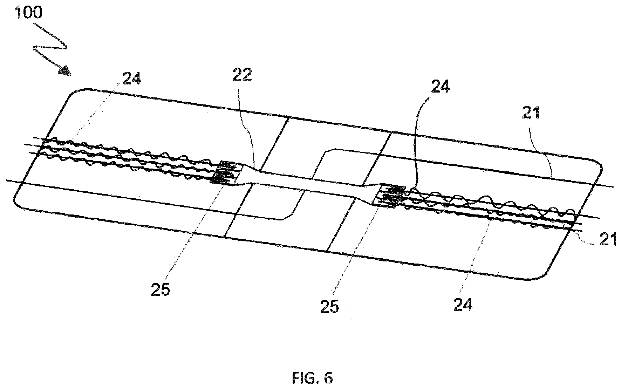

According to a further preferred aspect of the semi-finished product 100 or of the semi-finished product portion 100 according to the present disclosure, said semi-finished product 100 or portion of semi-finished product 100 can comprise a plurality of said single bodies. According to this preferred aspect, the single bodies of the plurality of single bodies are superimposed and associated with each other to form a single multilayer body. The single multilayer body is a singularly manoeuvrable or manageable element, comprising a plurality of single bodies overlapping or lying or lying on each other. In other words, the single multilayer body is basically a stack of single bodies. In particular, in said single multilayer body the glue layer 10 of each single body at least partially covers the electrically conductive component 20 of the one or more single bodies to which it is associated. The glue layer 10 of each single body protects and electrically insulates, at least partially, the electrically conductive component 20 of the one or more single bodies to which it is associated. As shown in figure 5 and in figure 6, the layers of glue 10 of the different single bodies can have different dimensions. The electrically conductive component 20 of a single body can also be fixed or partially associated with one of the layers of glue 10 of the single bodies with which it is in contact. The fixing or association between single bodies can take place at least by partial gluing or adhesion between the layers of glue 10 of adjacent single bodies. Alternatively, or in addition, an electrically conductive component 20 can also be partially fixed to the glue layer 10 of an adjacent single body, for example by means of sewing or embroidery stitches.

According to a preferred aspect of the present disclosure, the single bodies or single multilayer bodies are included between a first layer or piece of fabric 31 and a second layer or piece of fabric 32 to form the semi-finished product 100 or a portion of said semi-finished product 100. In other words, the semi-finished product 100 is a multilayer or "sandwich" structure comprising a single body or a single multilayer body enclosed between two layers or pieces of fabric, said first layer of fabric 31 and said second layer of fabric 32. Said first layer of fabric 31 and said second layer of fabric 32 are, for example, nylon patches.

Even more preferably, the semi-finished product 100 or the portion of said semi-finished product 100 further comprises a second layer of glue 13 and a third layer of glue 14. Also said second layer of glue 13 and third layer of glue 14 are similar to the layer of glue 10 of each single body. Respectively, the second layer of glue 13 is placed between the first layer of fabric 31 and the single body or the single multilayer body, while the third layer of glue 14 is placed between the second layer of fabric 32 and the single body or single multilayer body. The second layer of glue 13 and the third layer of glue 14 adhere at least partially to the glue layer 10 of the single body or bodies which are located at opposite ends or ends of the stack of single bodies in the single multilayer body.

According to another preferred aspect, alternative to the last preferred just discussed aspect, the semi-finished product 100 or the portion of said semi-finished product 100 comprises a first laminate 41 and a second laminate 42. Respectively, the first laminate 41 in turn includes a first layer or piece of fabric 31 and a second layer of glue 13 while the second laminate 41 includes, in turn, a second layer or piece of fabric 32 and a third layer of glue 14. Furthermore, according to this preferred aspect, the single body or the single multilayer body is included or enclosed or included between the first laminate 41 and the second laminate 42 to form said semi-finished product 100. The first laminate 41 and the second laminate adhere at least partially to the glue layer of the single body or bodies which they are found at opposite ends of the stack of single bodies in the single multilayer body. In this way, according to this preferred aspect as well as according to the previous preferred aspect, the electrically conductive components 20 of each single body are then covered and protected at least in part by a layer of glue coupled to a layer of fabric. In this way, at least a partial waterproofing of the single body or of the single multilayer body is achieved.

Preferably, the glue layer 10 of the single body or the glue layer of the single multilayer bodies which are located at the ends or ends at the opposite ends of the stack of single bodies in the single multilayer body adheres completely to the second layer of glue 13 and/or to the third layer of glue 14 or to the first laminate 41 and/or the second laminate 42. That is to say that, preferably, the layers of glue are joined to each other without interruption; or said otherwise, the layers of glue are completely joined to each other to form a single layer of glue. In other words, preferably, the layers of glue are joined to each other to form a continuous structure in which it is not substantially possible to distinguish one layer of glue from the other.

Finally, the present disclosure also refers to a production method for producing a semi-finished product 100 or a part of a semi-finished product 100 as described in detail up to now.

By describing this method, elements and components of the semi-finished product 100 or of the part of the semi-finished product 100, having the same function and the same structure as the previously described elements and components, retain the same reference number and are not again defined in detail.

The above method includes:
- providing a layer of glue 10 which is in fact a temporary layer, which is lost in a subsequent step;
- providin at least one electrically conductive thread 21
- providing at least one printed circuit board 22, preferably flexible;
- providing at least one additional thread or yarn 24; and
- associating the electrically conductive thread 21 on the disposable layer 10 and on the printed circuit board 20,
- embroidering or sewing the additional thread or yarn 24 so as to block the electrically conductive thread 21 on the disposable layer 10 and on the printed circuit board 20, obtaining a single body.

A possible technique for making said seam or embroidery of the additional thread or yarn 24 on said layer of glue 10 consists in associating the thread or yarn to the needle or needles of a traditional sewing or embroidery machine. Then, by means of a needle, a through hole is made on the printed circuit board through which said additional thread or yarn 24 is introduced. The additional thread or yarn is thus threaded through the glue layer 10. Preferably, the glue layer 10 is a sheet of glue. In other words, preferably, the glue layer is an independent element, that is to say individually manoeuvrable or manageable. Alternatively, the layer of glue 10 can be a layer of adhesive or a coat of glue pre-coupled or pre-associated with a piece or layer of fabric to form a so-called laminate.

The flexible printed circuit board 22 has at least one electrically conductive pad 22a. More particularly, the electrically conductive thread 21 is deposited directly on one or more conductive pads, and locked in this position by the thread or yarn 24. In practice, in this case the method provides for providing an electrically conductive thread 21, an additional thread or yarn, a flexible printed circuit board 22, having a plurality of conductive pads 22a, and to electrically connect said electrically conductive thread 21 to one or more of the conductive pads 22a of the flexible printed circuit board 22, by means of a thread or yarn 24 which can be independent of the electrical components, easy to stitch and not conductive. The electrical connection is made by embroidering or sewing the additional thread or yarn on said flexible printed circuit board 22 blocking the electrically conductive thread 21 at least in the region of the electrically conductive pad 22a. The additional thread or yarn is then threaded or passed at least through the thickness or the body of the electrically conductive pad 22a, preferably loosely, forming a wide winding. In particular, the electrically conductive thread 21 can be spread on the base of the flexible printed circuit board 22, and similarly the thread or yarn 24 sewn therein ,until at least one of the electrically conductive pads 22a is reached, so as to achieve a stable electrical connection. The electrical connection obtained according to this preferred aspect of the method is an intimate and stable physical contact between the material of the electrically conductive thread 21 and the material of which the electrically conductive pad 22a is made. Also in this case, a possible technique for making said stitching or embroidery on said flexible printed circuit board 22, or at least an electrically conductive pad 22a thereof, consists in associating the thread or yarn 24 to the needle or needles of a traditional sewing or embroidery machine. Then, by means of the needle, a through hole is made at least on an electrically conductive pad 22a; the thread or yarn is introduced into the hole through or inside said hole. In other words, the yarn or yarn 24 is threaded at least through the layer or thickness or body of the electrically conductive pad 22a, blocking the electrically conductive yarn.

In addition, according to the preferred aspect just described, in the method according to the present disclosure, connecting the electrically conductive thread 21 to at least one electrically conductive pad 22a by sewing or embroidering said thread or yarn at least in the region of the latter allows to associate or fixing the electrically conductive thread 21 and the flexible printed circuit board 22 to the glue layer 10, obtaining a single body, in a single production step. In fact, the electrically conductive thread 21 can be extended not only on one of the electrically conductive pads 22a but also on the glue layer 10 on which said flexible printed circuit board 22 on which it is placed, and the thread or yarn 24 sewn or embroidered matching the electrically conductive thread.

According to another preferred aspect, the method includes providing a plurality of said single bodies and superimposing and associating said plurality of single bodies with each other, to form a single multilayer body. In particular, the single bodies are arranged on each other so that the glue layer 10 of each single body at least partially covers the conductive component 20 of the one or more unique bodies to which it is associated. That is to say that the single bodies are arranged and associated, so that the glue layer 10 of each single body protects and electrically isolates, at least partially, the electrically conductive component 20 of the one or more single bodies with which it is in contact. In this case, the fixing or association of a single body to an adjacent one can take place at least by partial gluing or adhesion between the layers of glue 10. Alternatively, or in addition, an electrically conductive component 20 of a single body can be fixed, for example by placing stitches for sewing or embroidery, partly also on the glue layer 10 of an adjacent single body. Various portions of overlapping but isolated electrical and/or electronic circuits are thus created from each other.

According to another preferred aspect, the production method comprises providing a first fabric layer 31 and a second fabric layer 32, i.e. a first piece of fabric and a second piece of fabric. Furthermore, the method provides for including the single body or the single multilayer body between the first fabric layer 31 and the second fabric layer 32 to form said semi-finished product 100. Even more preferably, the method comprises providing a second layer of glue 13 and a third layer of glue 14 and to arrange the latter respectively between the single body or the single multilayer body and the first layer of fabric 31 and the second layer of fabric 32. In other words, the single body or the single multilayer body is enclosed or covered by a second layer of glue 13 and a third layer of glue 14 and then by a first layer of fabric 31 and a second layer of fabric 32. Therefore the single body or the single multilayer body is first associated with a second layer of glue 13 and a third layer of glue 14 and subsequently to a first layer of fabric 31 and a second layer of fabric 32. Alternatively, according to another preferred aspect, the semi-finished product is obtained by preparing a first laminate 41, including a first layer of fabric 31 and a second layer of glue 13, a second laminate 42, including a second layer of fabric 32 and the third layer of glue 14, and including the single body or the single multilayer body between the first laminate 41 and the second laminate 42.

The semi-finished product 100 thus obtained is a multilayer or "sandwich" structure, in which the electrically conductive component 20 of the single body or parts is incorporated or covered, then isolated or sealed or waterproofed, at least partially, by means of the second layer of glue 13 and a third layer of glue 14.

Finally, according to a further preferred aspect of the method of the present disclosure, the semi-finished product 100 can be subjected to thermo-pressing or thermo-forming, or a hot operation which allows the melting of the glue layer. During thermo-pressing or thermo-forming, the layers of glue 10, 13, 14 are heated at least until softening or up to a partial melting. The glue layer or the plurality of glue layers melt and are lost between the various layers during thermoforming or during similar hot operations.

Then, the different layers of the semi-finished product 100 are pressed together so that the layers of glue 10, 13, 14 join to each other to form a single or unitary layer, i.e. a seamless structure between the layers of glue 10, 13, 14. In this way, the electrically conductive component 20, and therefore also the electrically conductive tracks in the glue, are incorporated or completely embedded. In addition, the softened or melted glue can partially penetrate inside the meshes of said first fabric layer 31 and said second fabric layer 32, occupying the empty spaces between said meshes. It follows that said layers 31 and 32 are also waterproofed and therefore it is possible to obtain greater impermeability of the semi-finished product.

The object of the present disclosure has so far been described with reference to its embodiments. It is to be understood that other embodiments may exist which pertain to the same inventive scope, all falling within the protection scope of the claims set forth below.

## Claims

1. Production method for producing a semi-finished product (100) or a part of a semi-finished product (100), the method comprising:
- providing at least one disposable or temporary layer (10);
- providing at least one electrically conductive thread or yarn (21);
- providing at least one additional thread or yarn (24);
- providing at least one printed circuit board (22);
- associating the electrically conductive thread or yarn (21) to the disposable or temporary layer (10) and to the printed circuit board (22)
- embroidering or sewing the thread or yarn (24) on the disposable or temporary layer (10) and on the printed circuit board (22) by locking or stopping the electrically conductive thread or yarn (21) on the disposable or temporary layer (10) and on the printed circuit board (22).

2. Production method according to claim 1, wherein the disposable layer (10) is a thermoplastic layer, or a layer adapted to soften in the presence of heat, or more preferably a thermoplastic sheet or a sheet adapted to soften in the presence of heat and/or wherein the disposable layer (10) is a layer of glue, preferably a sheet of glue.

3. Method according to any one of the preceding claims, wherein the printed circuit board (22) is a flexible printed circuit board.

4. Method according to any one of the preceding claims, wherein the printed circuit board has at least one or more electrically conductive pad (22a) and the electrically conductive thread or yarn is deposited on the disposable layer and on the printed circuit board up to one or more electrically conductive pads and wherein embroidering or sewing the additional thread or yarn (24) on the disposable or temporary layer and on one or more of the electrically conductive pads (22a) of the printed circuit board (22) blocking the electrically conductive thread (21) take place in a single production phase by embroidering or sewing the additional thread or yarn (24) from the disposable layer (10) to said one or more electrically conductive pad (22a) and blocking the electrically conductive thread (21) in a stable position on the disposable layer (20) and on one or more electrically conductive pads (22a).

5. Method according to any one of the preceding claims, wherein the method provides for including the single body between at least two further layers (31, 32, 41, 42) and subjecting it to a heat treatment or processing with deformation and/or softening or melting of the disposable layer (10).

6. Method according to claim 5, wherein the semi-finished product (100) is subjected to a heat treatment, preferably by thermo-pressing or thermo-forming, and wherein, after thermo-pressing or thermoforming, the additional thread or yarn (24) is only sewn to the printed circuit board.

7. Method according to any one of the preceding claims, wherein in said semi-finished product (100) the electrically conductive thread or yarn (21) is not sewn or embroidered either to the disposable layer (20) or to the printed circuit board (22).

8. Semi-finished product (100) or part of a semi-finished product (100) comprising:
- at least one disposable layer or temporary layer (10);
- an electrically conductive thread or yarn (21);
- an additional thread or yarn (24)
- a printed circuit board (22);
- wherein the electrically conductive thread or yarn (21) rests on the disposable or temporary layer (10) and on the printed circuit board (22),
and a seam or embroidery, or a result of a seam or embroidery, of the additional thread or yarn (24), and wherein
said seam or embroidery of the additional thread or yarn (24) is designed to block or stop the electrically conductive thread or yarn (21) on the disposable layer or temporary layer (10) and on the printed circuit board (22).

9. Semi-finished product (100) or part of a semi-finished product (100) according to claim 8, wherein said disposable layer (10) is a thermoplastic layer, preferably a thermoplastic sheet, more preferably a sheet of glue, and more preferably still a polyurethane-based adhesive thermoplastic film.

10. Semi-finished product (100) according to any one of the preceding claims 8 or 9, wherein the printed circuit board (22) is a flexible printed circuit board.

11. Semi-finished product (100) or part of a semi-finished product (100) according to one of claims 8 to 10, wherein the printed circuit board (22) has one or more electrically conductive pads (22a) and the electrically conductive thread (21) is placed in contact on one or more of the conductive pads (22a) of the printed circuit board (22) and blocked or stopped there by means of said additional thread or yarn (24).

12. Semi-finished product (100) or part of a semi-finished product (100) according to any one of the preceding claims 8 to 11, comprising at least two further layers (13, 14, 31, 32, 41, 42), and wherein the body single is sandwiched between said at least two further layers (13, 14, 31, 32, 41, 42).

13. Semi-finished product (100) or part of a semi-finished product (100) according to any one of the preceding claims from 8 to 12, obtained according to the method of any one of claims 1 to 7.

14. Garment or portion of garment, or alternatively other wearable article or accessory, comprising a semi-finished product (100) or part of a semi-finished product (100) according to any one of claims 8 to 13.

15. Garment or portion of garment, or alternatively other wearable article or accessory according to claim 14, in which the additional thread or yarn (24) is sewn or embroidered only to the printed circuit board (22).
